# EUROPEAN PATENT SPECIFICATION

(11) **EP 1 907 160 B1**
(45) Date of publication and mention of the grant of the patent: **03.08.2011**
(21) Application number: 06744034.7
(22) Date of filing: 30.05.2006
(51) Int. Cl.: B23K 26/08, B23K 26/06, B81B 7/00, B23K 101/40

(54) **METHOD OF BONDING OF SURFACES WITH AN ADHESIVE CURED BY LASER**
VERFAHREN ZUM BONDEN VON FLÄCHEN MITTELS EINES KLEBSTOFFES, DER MIT LASER GEHARTET WIRD
PROCEDE DE FIXATION DE SURFACES AU MOYEN D'UN ADHESIF DURCI PAR UN FAISCEAU LASER

(30) Priority: 27.05.2005 GB 0510873
(43) Date of publication of application: 09.04.2008
(73) Proprietor: HERIOT-WATT UNIVERSITY, Edinburgh EH14 4AS (GB); IMEC, 3001 Leuven (BE)
(72) Inventor: WANG, Changhai, Edinburgh EH12 6JH (GB); HAND, Duncan, Edinburgh EH13 0QB (GB); BARDIN, Fabrice, 43 140 Saint Didier en Velay (FR)
(74) Representative: McNab, Donald C.
(86) International application number: PCT/GB2006/001971
(87) International publication number: WO 2006/126015

(56) References cited:
- DE-A1- 3 741 916
- US-A- 6 072 148
- US-A1- 2003 211 654
- US-A1- 2004 166 649
- US-B1- 6 809 412
- PATENT ABSTRACTS OF JAPAN vol. 017, no. 703 (P-1666), 22 December 1993 (1993-12-22) -& JP 05 241168 A (NEC KAGOSHIMA LTD), 21 September 1993 (1993-09-21)
- PATENT ABSTRACTS OF JAPAN vol. 018, no. 089 (P-1692), 14 February 1994 (1994-02-14) -& JP 05 290490 A (FUJITSU LTD), 5 November 1993 (1993-11-05)

## Description

The present invention relates to a method of bonding surfaces according to the preamble of claim 1 (see, for example, JP 5/241168), and, in particular, to the use of lasers to assist in the process of bonding surfaces to produce packaging within which microelectromechanical systems (MEMS) devices, micro-devices, micro-systems or the like may be contained.

MEMS devices are used in many products. For example, MEMS devices are used to provide miniature accelerometers that have applications in accident prevention, medical apparatus, telecommunications and in the provision of low cost printing. Whilst the devices themselves have changed and advanced to the extent that they are present in many commonplace products, the packaging of the devices has not advanced to the same extent.

One problem associated with the packaging of MEMS devices and with the semiconductor industry in general, is the ability to properly bond surfaces together without causing damage or minimising the damage caused to the surface and the MEMS devices during the bonding process. A number of bonding techniques are known, for example, anodic bonding, low temperature silicon direct bonding, soldering and thermo-compression bonding.

In addition, some use of laser radiation has been used to melt and reform metal to provide a connection.

US6394158B1 discloses the use of a laser to melt raised metal contacts in order to connect together a transparent substrate with another substrate. The laser transmits energy through the transparent substrate to heat touching pairs of metal contacts in sequence to form a secure connection between the substrates.

US6713714B1 discloses a method for thermally connecting the terminal areas of a carrier substrate by heating a chip to allow contacts to melt and re-solidify, thereby forming a connection.

It is an object of the present invention to provide a method of bonding surfaces that will allow bonding to occur between, for example, a pair of silicon substrates, a silicon substrate and a glass cover or the like.

In accordance with the invention there is provided a method of bonding surfaces according to claim 1.

Preferably, the laser beam is directed using a lens for focussing the laser beam onto an area of the surface.

Preferably, the laser beam cross sectional area is larger than the sample size.

Preferably, the laser is adapted to produce a patterned beam which is configured to illuminate the position of the curable adhesive on the substrate.

Preferably, the laser beam is directed using a transmission mask.

A transmission mask may be used in conjunction with the patterned beam.

Preferably, the curable adhesive is arranged in a predetermined pattern.

Preferably, the transmission mask is aligned with the curable adhesive predetermined pattern.

Preferably, the laser beam is directed onto the area of the surface in contact with the curable adhesive.

Preferably, the laser is scanned across the surface in a predetermined pattern.

Preferably, the laser directing means comprises an array of laser sources.

Preferably, the array is configured to allow a plurality of the laser sources in the array to be activated to form a predetermined pattern of illumination.

Optionally, the array of laser sources is arranged in a set pattern.

Preferably, the curable adhesive is a polymer.

Preferably the curable adhesive is a thermoplastic polymer.

Preferably, the curable adhesive is a thermosetting polymer.

Preferably, the curable adhesive is a photopolymer.

Preferably, the curable adhesive is benzocyclobutene.

Preferably, curable adhesive is positioned between two surfaces and is of sufficient thickness so as to separate the surfaces and form a gap between the surfaces.

Preferably, the curable adhesive has a thickness of at least 1 micron.

Preferably, the curable adhesive has a thickness of between 1 and 150 microns.

The curable adhesive layer thickness may be set to provide a predetermined cavity size.

Accordingly, a microcavity may be formed that is suitable for containing a MEMS device.

Preferably the curable adhesive is patterned in a ring shape.

Other suitable shapes may be used.

Preferably, the laser has a maximum power output of up to 1kW.

Preferably, the output power of the laser is more than 1W.

Preferably, a mechanical load is applied to the surface during bonding of the curable adhesive.

Preferably, the laser has an output wavelength in the infra-red region of the electromagnetic spectrum.

Preferably the system further comprises a laser transmission layer that extends across the substrate.

Preferably, the system further comprises a laser energy absorber layer.

Preferably, the pre-bonding step occurs under vacuum conditions, below standard atmospheric pressure. Preferably, the pre-bonding step occurs in a vacuum chamber.

The method according to the present invention allows localised laser heating using a laser beam and/or a mask to selectively direct the laser irradiation to the area(s) to be bonded. Therefore, the laser directing means may be a feature of the manner in which a laser beam is processed or created to pattern the beam or move the beam across a surface for example, and/or the use of a mask. The laser directing means functions to allow the laser to selectively heat the curable adhesive to lessen or minimise heat transfer to the surrounding substrate(s).

Therefore the temperature increase at the device location can be lower than at the bonding/sealing area. The lower temperature at the device position is very desirable for devices with low temperature budget such as RF MEMS switch structures. Excessive temperature rise can cause failure of switches due to stress change in the membrane films. Because laser heating is localised, rise and fall of temperature can be much faster compared with oven and hotplate based heating methods therefore reducing exposure of MEMS to prolonged heating.

Localised laser heating is particularly useful for chip to chip and chip to wafer packaging, allowing attachment of caps individually to encapsulate MEMS devices with minimal thermal load to the other uncapped and capped devices.

The present invention will now be described by way of example only, with reference to the accompanying drawings in which:
Fig.1 illustrates laser curing of an adhesive onto a substrate surface not covered by the present invention;
Fig.2 is a graph showing the effect of different conditions upon the curing of the adhesive;
Fig.3 illustrates two surfaces separated by a layer of curable adhesive;
Fig.4. illustrates an example of the process of laser curing not covered by the present invention;
Fig. 5 illustrates a system not covered by the present invention in which a curable adhesive is bonded to two surfaces;
Fig.6 is a graph showing the temperature variation over time during laser curing in accordance with the present invention;
Fig.7 illustrates system in accordance with the present invention in which a curable adhesive is bonded to two surfaces and a transmission mask is used to allow laser transmission to the surface and adhesive;
Fig.8a to Fig 8c show plan views of a number of microcavities not covered by the invention;
Fig.9 illustrates localised laser heating on an absorbing layer;
Fig.10a to Fig.10f illustrates the effect of the focal position of a laser beam on heating of a silicon wafer surface;
Fig.11 is a graph showing measured temperature of a silicon surface as a function of laser power for different positions relative to the laser focus;
Fig.12a to Fig12c are photographs of an exemplary uncured BCB ring;
Fig.13 is a schematic view of a further embodiment of the present invention in which a heat absorbing layer is included;
Fig. 14 is a schematic view of a further embodiment of the present invention in which a patterned beam is used;
Fig. 15 is a schematic view of a further embodiment of the present invention in which a patterned beam and optical mask is used;
Fig.16 is a schematic view of a diode laser source for use with the system not covered by the present invention;
Fig.17 is a schematic view of a fibre optic laser source for use with the system not covered by the present invention;
Fig.18 is a schematic figure that shows a feature of the present invention in which a pre-bonding step is performed under atmospheric pressure;
Fig.19 is a schematic figure that shows a feature of the present invention in which a pre-bonding step is performed in a vacuum chamber; and
Fig. 20 is a schematic figure that shows the laser heating step used in a method having a pre-bonding step according to the present invention.

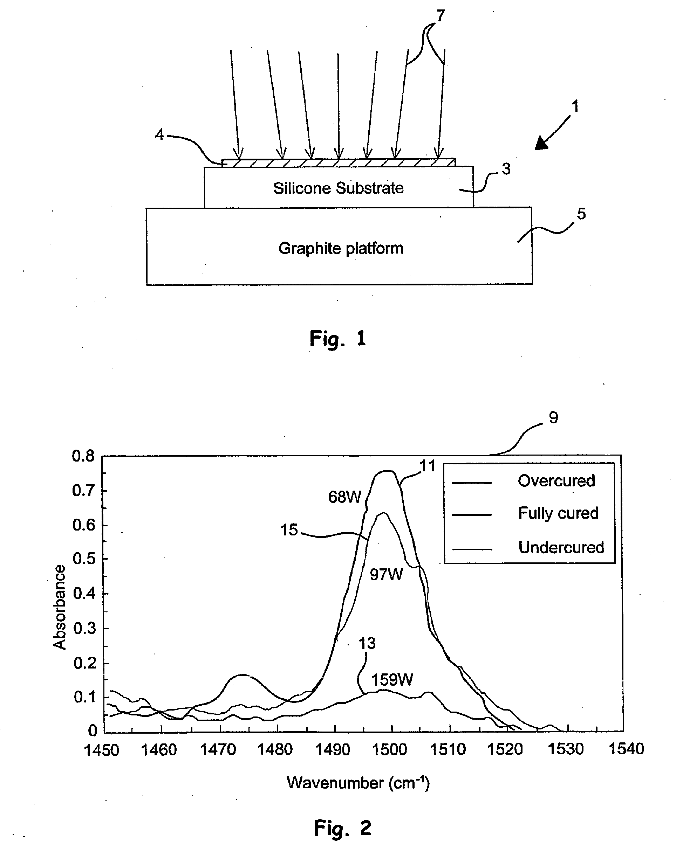

Fig.1 shows a system 1, in which a silicon substrate 3 mounted on a graphite platform 5 is selectively coated or patterned with a curable adhesive film 4 and cured using laser beam 7 which selectively heats the area of the substrate to which the adhesive is applied. Suitably, the adhesive film 4 is a blank/uniform BCB film on a 10mm square silicon substrate.

The response of the surface to temperature changes can be characterised by monitoring the surface temperature of the BCB film 4 using a pyrometer. The operating current of the laser system can be used to control the exposure of BCB film 4 to laser irradiation 7 and the exposure time can be controlled by switching the laser on and off.

Fourier Transform Infra-red (FTIR) measurements on samples created using the system of the present invention show that the sample cured with a laser operating at 68W was undercured 11, the sample cured with a laser operating at 159W was overcured and the sample cured with a laser operating at 97W was fully cured. The undercured sample shows an absorption peak at the wavenumber of 1474 cm⁻¹. This absorption peak is the characteristic of undercured BCB film. The results are presented in the graph 9 of Fig.2.

The fully cured sample was not damaged, as it shows no absorption peak at 1474 cm⁻¹ but a large absorption peak at 1550 cm⁻¹. The overcured sample was damaged by the laser curing and does not show either absorption peak.

Conveniently, a large beam area is used to obtain better uniformity of exposure of the BCB samples. As the laser beam intensity distribution is not uniform across the beam, the intensity variation across a sample is less if the beam size is much larger than the sample size. The result can be a substantially uniform exposure. Though the laser has maximum output of 1 kW, less than 200 W was sufficient for the laser bonding work to be presented. Where this type of beam is used a mask is provided to ensure that the laser radiation is incident on the curable material.

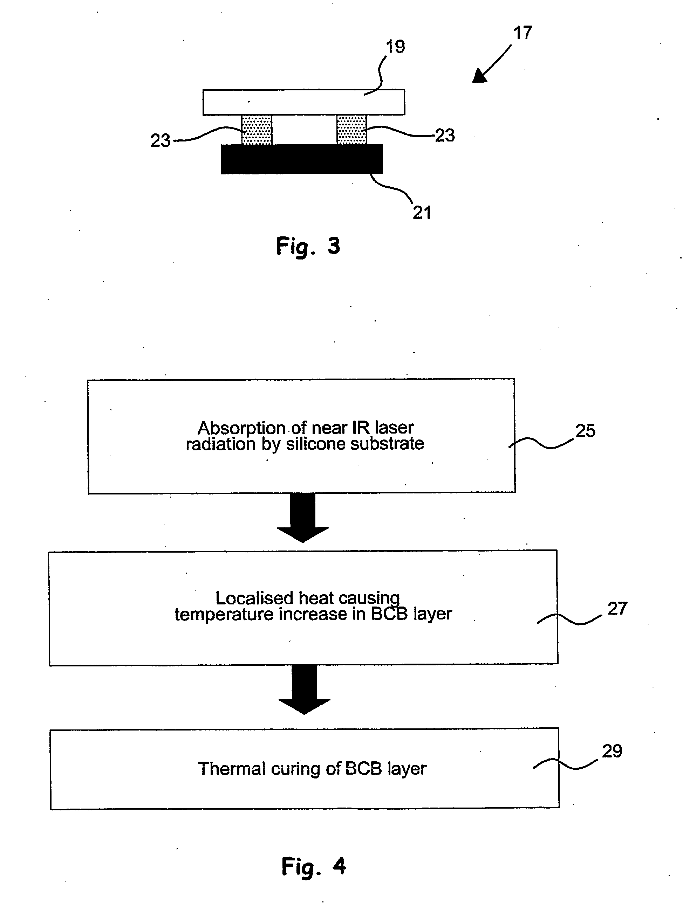

Fig.3 shows a microcavity . The microcavity 167 is bounded by a glass cover 19, a silicon substrate 21 and a polymer ring 23 (in this example made from benzocyclobutene) which is of sufficient thickness to provide a cavity of suitable depth to accommodate a MEMS device.

Figure 4 shows an example of part of the method of the present invention. Firstly near IR laser radiation is absorbed by the silicon substrate 25; localised heating causes a temperature increase in the BCB layer 27 which causes thermal curing of the BCB layer 29.

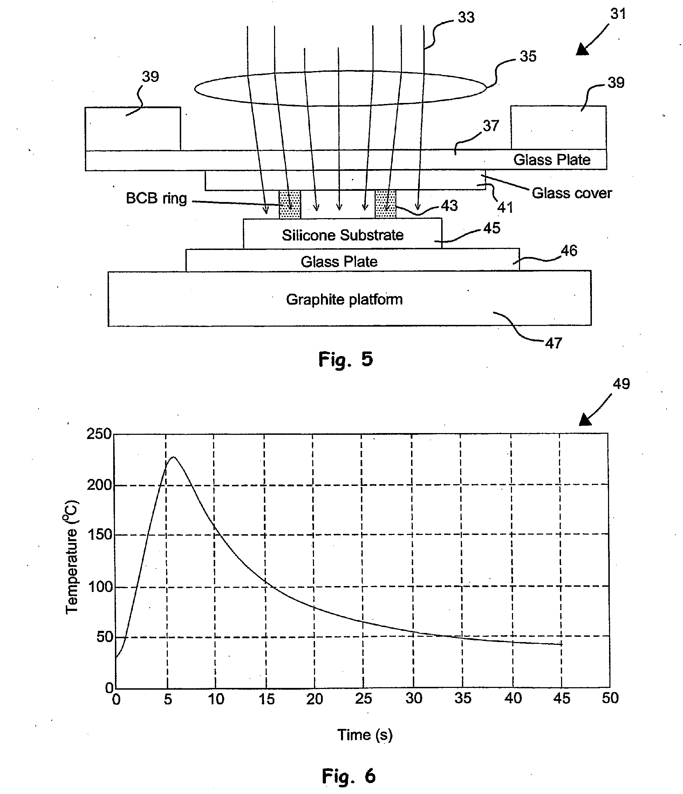

Fig. 5 shows a system 31, which comprises a laser 33 transmitted through a converging lens 35 and transmitted through a glass plate 37 and glass cover 41 to selectively heat an area containing the BCB ring 43 and the silicon substrate 45. The silicon substrate is supported on a second glass plate 46 and a graphite platform 47. This glass plate 46 was used to achieve reproducible contact between the silicon substrate 45 and glass plate 46.

The size of the silicon substrates 45 with square BCB rings 43 is suitably 4mmx4mm. The glass cover 41(8mmx8mm) to be bonded to the BCB ring 43 is placed on top of the ring 43 with another glass plate 37 being placed on top of the glass cover 41 for applying mechanical load to the glass cover for bonding. Metal bars 39 are used as the mechanical load. The temperature of the top surface of the load glass plate 37 can be monitored with a pyrometer during the bonding process.

Fig.6 is a graph 49 which shows the profile of temperature change of the top surface of the load glass plate during and after the exposure process, as monitored with a pyrometer for an exposure time was 6 seconds and laser power 131 W. The corresponding temperature within the BCB layer is higher than that shown by the graph, because of the temperature gradient in the glass cover and the load glass plate. The dynamic temperature change during the bonding process can be monitored using the pyrometer. Thermal modelling allows the determination of the actual temperature change as time in the BCB layer.

A range of bonding parameters allow uniform bonding. The bonding time can range from 6 seconds to minutes by choosing appropriate power levels. In general, a shorter bonding time requires higher laser power, and a higher curing temperature results in shorter curing time. It is possible to achieve good bonding at exposure times shorter than 6 seconds. Mechanical loads of 360 g and 580 g have been used to achieve uniform bonding.

Laser bonding of the glass cap to silicon chip using a BCB sealing ring can be achieved using exposure times of 6 seconds, more than 100 times faster than the times achieved using conventional "global" heating methods. The fast laser bonding process enables efficient manufacture of micro & nano systems with uniform bonding across the BCB sealing rings and minimises the heat stress in the device.

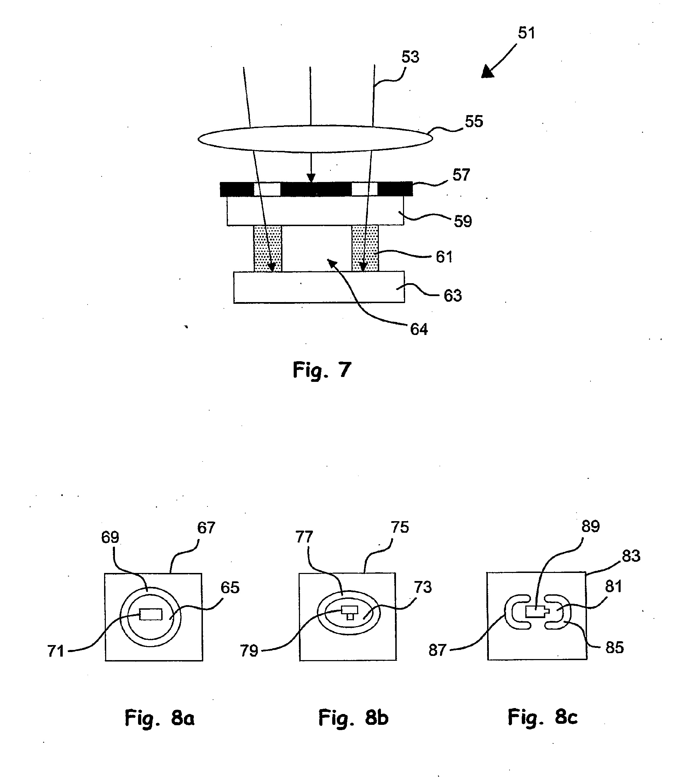

Fig. 7 shows a further example of the system, 51, which comprises a laser beam 53 a converging lens 55, a transmission mask 57, a glass cover 59 a BCB ring 61 and a substrate 63. In this example, the system is used to produce microcavities for encapsulation and packaging micro-devices and micro-systems. In this example, the polymer (BCB) is suitably between 2 and 100 microns thick and provides an intermediate joining layer that separates the glass cover 59 and the substrate 63 to form the cavity 64.

As shown in the figure 7, two substrates are bonded by laser curing the polymer ring 61 through a transmission mask 57. Alternatively, this can be achieved by scanning a focussed beam along the polymer ring 61. The thick polymer layer bonds and joins two surfaces of the polymer ring 61 and the inner surfaces of the two substrates 59 and 63. This is different from laser welding of plastic parts in which the joining is between the surfaces of the two joining parts. Although in some cases a very thin absorbing layer of polymer is used in laser welding of plastics the actual joining is still between the surfaces the joining parts.

Fig.8a to Fig 8c show plan views of a number of microcavities 65,73,81 containing MEMS devices 71,79,89. Fig. 8a illustrates a MEMS device 71 encapsulated in the microcavity 65 formed by the polymer ring 69 on the substrate 67. Similarly, Fig. 8b illustrates a MEMS device 79 encapsulated in a more irregularly shaped microcavity 73 formed by a thicker and more eccentrically shaped polymer ring 77 on the substrate 75. Finally, Fig. 8c illustrates a MEMS device 89 held within a microcavity 81 formed by two sections 85, 87 of a noncontinuous polymer ring on the substrate 89.

The substrates can be glass, silicon, ceramics, plastics and metal. The substrates can be flat or can have a recess or recesses.

One substrate may be transparent to the laser beam. Absorption of laser radiation for thermocuring of the polymer ring can be achieved using substrate absorption, or absorption by the polymer layer. If the polymer is transparent, absorbing agents such as carbon powder or chemical molecules can be added to produce absorption in the polymer layer. An additional absorbing layer between the adhesive layer and one or both substrates can also be used to provide absorption and hence temperature rise for curing the adhesive layer.

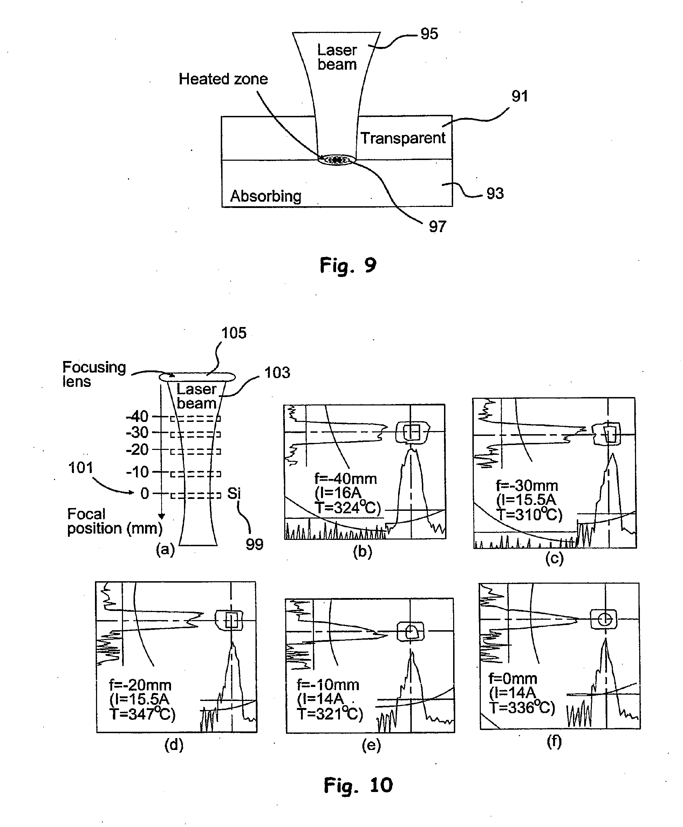

Fig.9 illustrates schematically this process. The bonding layers comprise a transparent top layer 91 and an absorbing bottom layer 93. A laser beam 95 is incident on the absorbing layer 93 having passed through the transparent layer 91, and a heated zone 97 is created. An absorbing intermediate layer (not shown) may also be used.

Fig.10a to Fig.10f illustrates the effect of the focal position on heating of a silicon wafer surface. Fig.10a is a schematic drawing of the position of the silicon wafer 99 with respect to the focal point 101 of a laser beam 103 focussed by a focussing lens 105. Fig.10b to 10f show thermal imaging photographs in false colour and gradient temperature profiles of a 10x10mm² silicon wafer under laser radiation for focal positions; (b)=-40mm, (c)=-30mm, (d)=-20mm, (e)=-10mm and (f)=0mm.

Temperatures were measured by single point pyrometer rendering average surface temperatures of; (b)=324°C, (c)=310°C, (d)=347°C, (e)=321°C and (f)=336°C.

This clearly illustrates how the temperature of the substrate can be varied without necessarily varying the laser power, and as such a feedback loop can be envisaged whereby the pyrometer provides feedback to control the position of the wafer.

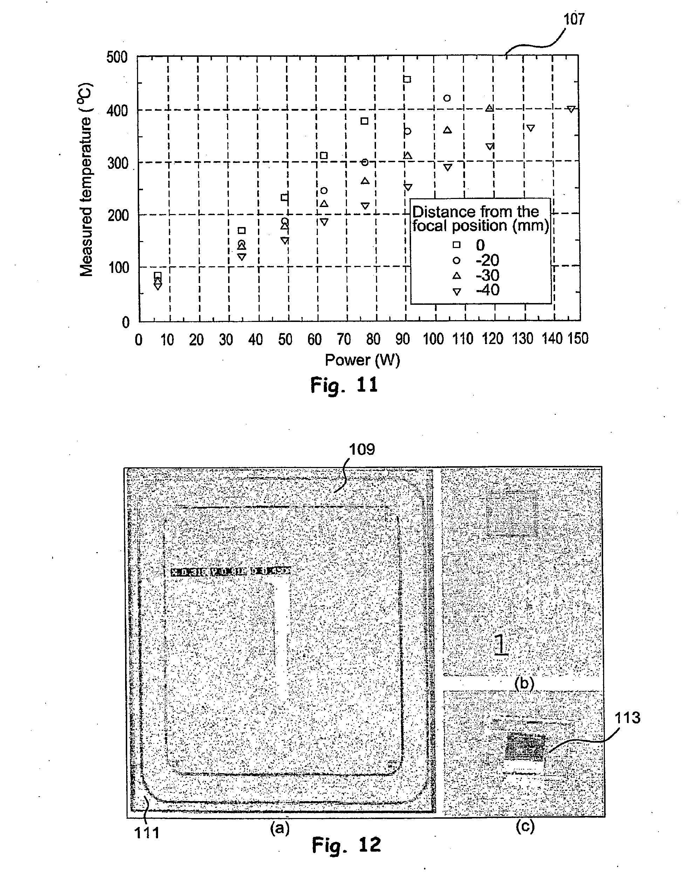

Fig.11 shows a graph 107 which demonstrates the measured temperature on a 10x10 mm² silicon surface for different positions relative to the laser focus position.

Fig.12a and 12b are photographs of an uncured BCB ring 109 before laser radiation has been applied. The BCB ring 109 has been formed on a silicon 4x4mm² substrate 111, and is around 320µm wide. Fig.12c shows the covering glass 113 in place. Such a configuration would be used to bond the silicon substrate to the glass in accordance with the method exemplified in Fig.5.

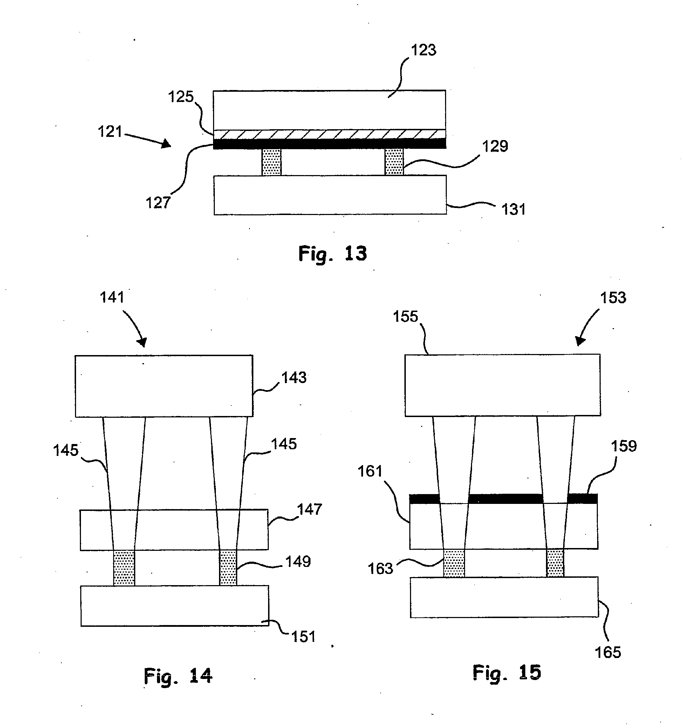

Fig.13 is a schematic view , in which alight absorbing layer is included. The system is shown without the laser source or laser directing means. The system 121 comprises a transparent cap 123, an adhesion layer 125 which holds the absorbing layer 127 in place in proximity with the curable adhesive 129, which is also positioned on a substrate 131.

In this case, the absorbing layer 127 comprises a thin layer of metal or other optically absorbing material which has been deposited on the surface of the transmission cap 123 or on the substrate/wafer 131 to act as the contacting surface to the adhesive layer 129. This additional layer 127 acts as a uniform absorber to absorb laser energy to produce the required temperature rise to cure the adhesive.. Advantageously, a lower temperature rise in the MEMS device structure may be caused, thereby reducing thermal effects on the device. In these circumstances, the device substrate need not be used to absorb the laser energy.

A thin layer of chromium or titanium 125 may be used to improve the adhesion of the metal layer to the capping substrate 123. The thickness of the metal film, e.g. nickel, is typically 100 nm to 10 um and is produced by vacuum deposition and/or electrodeposition or electroless deposition. The thickness of the chromium/titanium layer is typically in the region of 10 nm to 500 nm and is produced by vacuum deposition.

Fig. 14 is a schematic view , in which a patterned beam is used The system 141 shows a laser 143 that produces a patterned beam 145 incident upon a transparent cap 147 and which heats the curable adhesive 149 on substrate 151. The laser beam 143 with patterns produced using beam forming optics illuminates the areas to be bonded between the cap 147 and substrate 151.

A laser beam with a predetermined pattern matching that of the adhesive is preferred. This improves the efficiency of the usage of the laser energy as most laser light is directed to the bonding area. The beam pattern can be generated using reflective and/or refractive optics.

Figure 15 shows a system similar to that of figure 14 comprising a laser 155 that produces a patterned beam 157 incident upon a transparent cap 161 and which heats the curable adhesive 163 on substrate 165. The system of figure 15 further comprises an optical mask 159.

The optical mask 159 has been added in the beam path to remove peripheral light from the laser beam to ensure that only the adhesive pattern is illuminated. A laser beam with a predetermined pattern reduces the risk of damaging the optical mask by high intensity light.

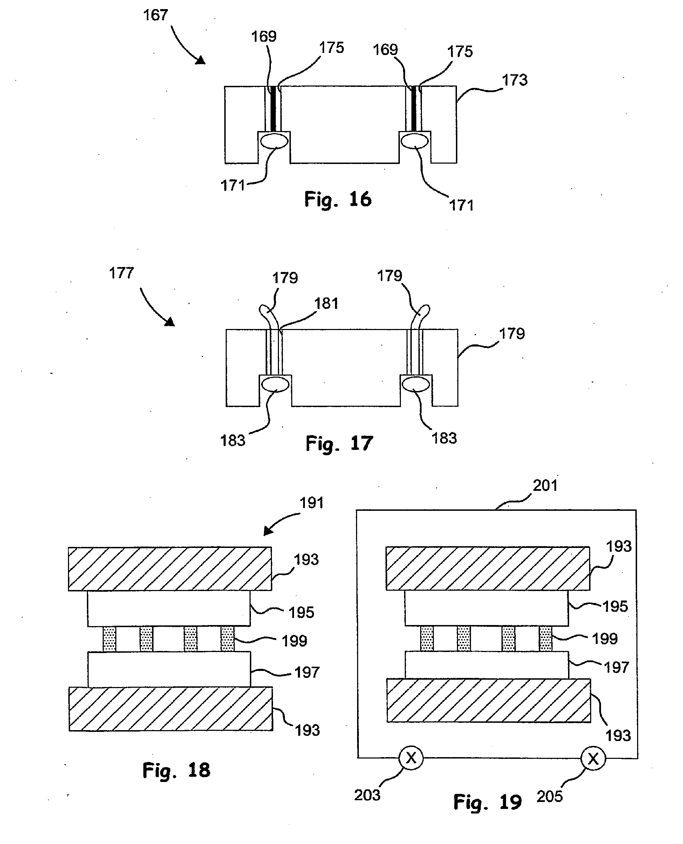

Fig.16 is a schematic view of a diode laser source . The diode laser source comprises an array 167 of diode lasers 169 mounted in a chuck or block 173, each of which is provided with a microlens array 171 at the end of channel 175.

In this case, the array 167 of diode lasers 169 mounted on a block 173 is pointed to the joining interface with or without lenses and near field illumination is used to heat up the substrate and the joining material to join two substrates together.

In this case, diode laser bars each containing a linear or two dimensional array of lasers, may be arranged in a pattern matching that of the adhesive for bonding two substrates together. In this case the lasers are mounted on a bonding chuck 173 together with the force applicator. This will result in a compact, low cost bonding head that can be fitted onto existing commercial device bonders with minimal modification.

The diode array can also be selectively turned on and off to change the output beam pattern as required for a particular application. Microlens arrays can be integrated with the laser bars to shape the laser beam to produce a beam pattern to match that of the adhesive.

Fig.17 is a schematic view of a fibre optic laser source . The figure shows an array of optical fibres 177, a chuck 179, a channel 181 in which the fibres are mounted and a Microlens 183. The array of optical fibres 177 mounted on a block or chuck 179 is pointed at the joining interface with or without lenses to heat up the substrate and the joining material to join two substrates together.

In this case, the required beam pattern is generated using an array of optical fibres 177 each delivering a single laser beam. The optical fibres 177 are mounted in a block by inserting the fibres in the holes produced on the block made of metal, ceramic or glass material. This approach does not require active cooling of the block as may be the case is may be required if the lasers are directly mounted on the block.

The block itself can be part of the bonding chuck with a force applicator. The Microlens arrays 183 can be integrated with the fibre array 177 to shape the laser beam to produce a beam pattern to match that of the adhesive.

Figures 18 to 20 illustrate an example of a method in accordance with the present invention in which a pre-bonding step using conventional bonding is used in conjunction with a final bonding step that uses laser heating.

Figure 18 shows an example in which the pre-bonding step occurs in an ambient environment. In this case, the system 191 comprises a chuck 193, wafers 195 and 197, and an adhesive 199.

Figure 19 shows the features of figure 18 enclosed in a vacuum chamber 201 having a gas inlet 203 and a gas outlet 205.

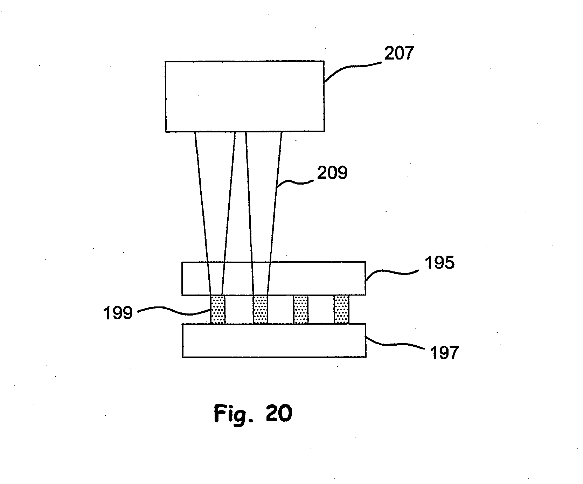

The laser heat bonding step is shown in figure 20. This step completes the curing process. Figure 20 shows a laser 207 that generates a patterned beam 209, wafers 195 and 197 along with the curable adhesive 199.

In this two step laser bonding process, the substrates/wafers 195, 197 are aligned and pre-bonded using a conventional wafer bonder to allow partial curing of the adhesive (Figures 18 and 19). Then localised laser heating is used to complete the full curing process at a higher temperature. For example for BCB adhesive, the pre-curing may be realised below 170ºC degrees and the full curing above 250ºC using localised laser heating.

Advantageously, this removes the requirement of coupling laser beam into a vacuum chamber for vacuum packaging. This method also allows decoupling of force application and laser bonding. In wafer bonding a large bonding force is necessary to achieve good contact between the two wafers. But the chuck for force application is often not transparent to the laser beam, therefore it is difficult to combine laser heating and force application at the same time. It is a great advantage to remove the force requirement for laser assisted bonding.

Laser bonding can be achieved by projecting the laser onto the adhesive patterns to cure it in a stepped manner or by scanning a laser beam. Masks may be used to expose only the adhesive patterns to the laser beam. The scanning beam can be in any chosen cross-sectional distribution by using beam shaping optics.

The polymer material can be a thermosetting material such as benzecyclobutene (BCB) or a thermoplastic material. Polymers that can be patterned by photolithography are preferred. Polymer rings may also be produced by stencil printing and inkjet printing.

The photopatterning capability is an important advantage of the polymer curable adhesive such as BCB when used as a sealing/bonding material for MEMS encapsulation.

Additional films (organic, inorganic or metal) may be deposited on the substrates to improve the adhesion strength of the adhesive bonding layer and to provide a tightly sealed cavity.

Improvements and modifications may be incorporated herein without deviating from the scope of the invention as defined in the appended claims.

## Claims

1. A method of bonding surfaces (19, 41, 59 ; 21, 45, 63), the method comprising the steps of:
depositing a curable adhesive (23, 43, 61) between two surfaces;
directing a laser beam (33, 53) onto the surface to selectively heat the area of the surface in thermal contact with the curable adhesive to cause the curable adhesive to bond to the surface, **characterised in that** prior to directing the layer beam (33,53) onto the surface, aligning and pre-bonding the two surfaces in a pre-bonding step at a temperature lower than that required to fully cure the adhesive using laser heating; and the curable adhesive is patterned such that a cavity (64) is formed, the cavity (64) being bonded, at least in part by the curable adhesive (23,43,61).

2. A method as claimed in claim 1 wherein, the laser beam (33, 53) is directed using a lens (35, 55) for focussing the laser beam (33,53) onto an area of the surface.

3. A method as claimed in claim 1 or claim 2 wherein, the laser beam (33,53) cross sectional area is larger than the sample size.

4. A method as claimed in claims 1 to 3 wherein, the laser is adapted to produce a patterned beam which is configured to illuminate the position of the curable adhesive (23, 43, 61) on the substrate.

5. A method as claimed in claims 1 to 4 wherein, the laser beam (33, 53) is directed using a transmission mask (57).

6. A method as claimed in claims 1 to 5 wherein, the curable adhesive (23, 43, 61) is arranged in a predetermined pattern to form the cavity (64).

7. A method as claimed in claim 6 wherein, the transmission mask (57) is aligned with the curable adhesive predetermined pattern.

8. A method as claimed in claims 1 to 7 wherein, the laser is scanned across the surface in a predetermined pattern.

9. A method as claimed in claims 1 to 7 wherein a plurality of the laser sources are provided in an array which are activated to form a predetermined pattern of illumination.

10. A method as claimed in claim 9 wherein, the array of laser sources is arranged in a set pattern.

11. A method as claimed in claims 1 to 10 wherein the curable adhesive (23, 43, 61) positioned between two surfaces (19, 41, 59 and 21, 45, 63) is of sufficient thickness so as to separate the surfaces and form a gap between the surfaces.

12. A method as claimed in claims 1 to 11 wherein, a mechanical load (39) is applied to the surface (19, 41, 59; 21, 45, 63) during bonding of the curable adhesive (23, 43, 61).

13. A method as claimed in any on eof claims 1 to 12 wherein, the pre-bonding step occurs under vacuum conditions, below standard atmospheric pressure.

14. A method as claimed in claim 13 wherein, the pre-bonding step occurs in a vacuum chamber (201).

## Patentansprüche

1. Verfahren zum Bondieren von Flächen (19, 41, 59; 21, 45, 63), wobei das Verfahren die folgenden Schritte umfasst:
das Aufbringen eines aushärtbaren Klebstoffs (23, 43, 61) zwischen zwei Flächen,
das Richten eines Laserstrahls (33, 53) auf die Fläche, um selektiv den Bereich der Fläche in thermischem Kontakt mit dem aushärtbaren Klebstoff zu erhitzen, um zu bewirken, dass sich der aushärtbare Klebstoff an die Fläche bondiert, **dadurch gekennzeichnet, dass**, vor dem Richten des Laserstrahls (33, 53) auf die Fläche, die zwei Flächen in einem Vorbondierungsschritt bei einer Temperatur, die niedriger ist als diejenige, die zum völligen Aushärten des Klebstoffs notwendig ist, ausgerichtet und unter Verwendung der Lasererhitzung vorverbunden werden und der aushärtbare Klebstoff gemustert ist derart, dass ein Hohlraum (64) geformt wird, wobei der Hohlraum (64), wenigstens teilweise, durch den aushärtbaren Klebstoff (23, 43, 61) bondiert wird.

2. Verfahren nach Anspruch 1, wobei der Laserstrahl (33, 53) unter Verwendung einer Linse (35, 55) zum Fokussieren des Laserstrahls (33, 53) auf einen Bereich der Fläche gerichtet wird.

3. Verfahren nach Anspruch 1 oder Anspruch 2, wobei die Querschnittsfläche des Laserstrahls (33, 53) größer ist als die Probengröße.

4. Verfahren nach Anspruch 1 bis 3, wobei der Laser dafür eingerichtet ist, einen gemusterten Strahl zu erzeugen, der dafür konfiguriert ist, die Position des aushärtbaren Klebstoffs (23, 43, 61) auf dem Substrat zu beleuchten.

5. Verfahren nach Anspruch 1 bis 4, wobei der Laserstrahl (33, 53) unter Verwendung einer Übertragungsmaske (57) gerichtet wird.

6. Verfahren nach Anspruch 1 bis 5, wobei der aushärtbare Klebstoff (23, 43, 61) in einem vorbestimmten Muster angeordnet wird, um den Hohlraum (64) zu formen.

7. Verfahren nach Anspruch 6, wobei die Übertragungsmaske (57) mit dem vorbestimmten Muster des aushärtbaren Klebstoffs ausgerichtet wird.

8. Verfahren nach Anspruch 1 bis 7, wobei der Laser in einem vorbestimmten Muster über die Fläche gleiten lassen wird.

9. Verfahren nach Anspruch 1 bis 7, wobei mehrere der Laserquellen in einer Gruppierung bereitgestellt werden, die aktiviert werden, um ein vorbestimmtes Beleuchtungsmuster zu formen.

10. Verfahren nach Anspruch 9, wobei die Gruppierung von Laserquellen in einem festgesetzten Muster angeordnet wird.

11. Verfahren nach Anspruch 1 bis 10, wobei der zwischen zwei Flächen (19, 41, 59 und 21, 45, 63) angeordnete aushärtbare Klebstoff (23, 43, 61) eine ausreichende Dicke hat, so dass er die Flächen trennt und einen Spalt zwischen den Flächen bildet.

12. Verfahren nach Anspruch 1 bis 11, wobei während des Bondierens des aushärtbaren Klebstoffs (23, 43, 61) eine mechanische Belastung (39) auf die Fläche (19, 41, 59; 21, 45, 63) ausgeübt wird.

13. Verfahren nach Anspruch 1 bis 12, wobei der Vorbondierungsschritt unter Vakuumbedingungen, unterhalb des atmosphärischen Standarddrucks, stattfindet.

14. Verfahren nach Anspruch 13, wobei der Vorbondierungsschritt in einer Vakuumkammer (201) stattfindet.

## Revendications

1. Procédé d'assemblage par précollage de surfaces (19, 41, 59 ; 21, 45, 63), le procédé comprenant les étapes ci-dessous :
dépôt d'un adhésif durcissable (23, 43, 61) entre deux surfaces ;
direction d'un faisceau laser (33, 53) sur la surface, pour chauffer sélectivement la zone de la surface en contact thermique avec l'adhésif durcissable, pour entraîner le collage de l'adhésif durcissable sur la surface, **caractérisé en ce que**, avant de diriger le faisceau laser (33, 53) sur la surface, les deux surfaces sont alignées et précollées lors d'une étape de précollage en présence d'une température inférieure à celle requise pour durcir complètement l'adhésif par l'intermédiaire d'un chauffage au laser ; et l'adhésif durcissable est muni d'un motif, de sorte à établir une cavité (64), la cavité (64) étant collée, au moins en partie, par l'adhésif durcissable (23, 43, 61).

2. Procédé selon la revendication 1, dans lequel le faisceau laser (33, 53) est dirigé par l'intermédiaire d'une lentille (35, 55) pour focaliser le faisceau laser (33, 53) sur une zone sur la surface.

3. Procédé selon les revendications 1 ou 2, dans lequel la surface de section transversale du faisceau laser (33, 53) est plus grande que la taille de l'échantillon.

4. Procédé selon les revendications 1 à 3, dans lequel le laser est adapté pour produire un faisceau à motif, configuré de sorte à éclairer la position de l'adhésif durcissable (23, 43, 61) sur le substrat.

5. Procédé selon les revendications 1 à 4, dans lequel le faisceau laser (33, 53) est dirigé par l'intermédiaire d'un masque de transmission (57).

6. Procédé selon les revendications 1 à 5, dans lequel l'adhésif durcissable (23, 43, 61) est agencé dans un motif prédéterminé pour former la cavité (64).

7. Procédé selon la revendication 6, dans lequel le masque de transmission (57) est aligné avec le motif prédéterminé de l'adhésif durcissable.

8. Procédé selon les revendications 1 à 7, dans lequel le laser est balayé à travers la surface dans un motif prédéterminé.

9. Procédé selon les revendications 1 à 7, dans lequel plusieurs sources laser sont agencées dans un réseau, et sont actionnées pour former un motif d'éclairage prédéterminé.

10. Procédé selon la revendication 9, dans lequel le réseau de sources laser est agencé dans un motif défini.

11. Procédé selon les revendications 1 à 10, dans lequel l'adhésif durcissable (23, 43, 61), positionné entre deux surfaces (19, 41, 59 et 21, 45, 63), a une épaisseur suffisante pour séparer les surfaces et former un espace entre les surfaces.

12. Procédé selon les revendications 1 à 11, dans lequel une charge mécanique (39) est appliquée à la surface (19, 41, 59 ; 21, 45, 63) au cours du collage de l'adhésif durcissable (23, 43, 61).

13. Procédé selon l'une quelconque des revendications 1 à 12, dans lequel l'étape de précollage est exécutée dans des conditions de vide, au-dessous de la pression atmosphérique standard.

14. Procédé selon la revendication 13, dans lequel l'étape de précollage est exécutée dans une chambre à vide (201).
